# EUROPEAN PATENT SPECIFICATION

(11) **EP 2 031 715 B1**
(45) Date of publication and mention of the grant of the patent: **16.08.2017**
(21) Application number: 07115212.8
(22) Date of filing: 29.08.2007
(51) Int. Cl.: H01S 5/0625, H01S 5/0687, H01S 5/06, H01S 5/12

(54) **Reduction of wavelength tuning time of laser diodes**
Verkürzung der Zeitdauer der Wellenlängenänderung von Laserdioden
Réduction du temps de réglage de la longueur d'onde de diodes laser

(43) Date of publication of application: 04.03.2009
(73) Proprietor: Intune Networks Limited, 12 Dublin (IE)
(72) Inventor: Farrell, Thomas, Dublin 12 (IE)
(74) Representative: Purdylucey Intellectual Property

(56) References cited:
- EP-A- 1 291 988
- EP-A- 1 432 087
- US-A1- 2002 075 918
- US-A1- 2003 147 442
- US-A1- 2004 120 372

## Description

### Field of the Invention

The invention relates to switching of tunable lasers so that the switching time to change the laser from one wavelength to another wavelength is reduced. The invention is particularly suitable, but not exclusively, for optical communications.

### Background to the Invention

The invention relates to a multi-section laser diode that can be switched between different wavelengths, more especially to a laser system comprising a control circuit that enables a multi-section laser diode to be switched rapidly between different wavelengths.

A typical multi-section diode laser is a three-section tunable distributed Bragg reflector (DBR) laser. Other types of multi-section diode lasers are the sampled grating DBR (SG-DBR) and the superstructure sampled DBR (SSG-DBR) which both have four sections. A further multi-section diode laser is the grating-assisted coupler with rear sampled or superstructure grating reflector (GCSR), which also has four sections.

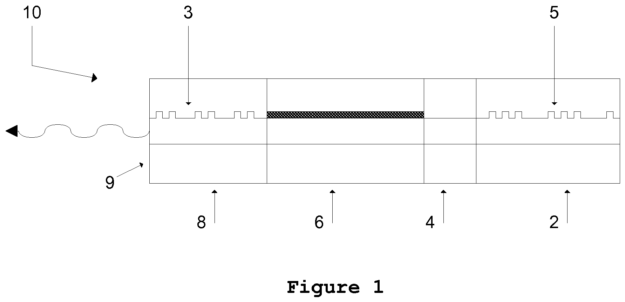

Figure 1 is a basic schematic drawing of a SG-DBR 10. The laser comprises back and front reflector sections 2 and 8 with an intervening gain or active section 6 and phase section 4. An antireflection coating 9 is usually provided on the front and/or rear facet of the chip to avoid facet modes. The back and front reflectors take the form of sampled Bragg gratings 3 and 5. The pitch of the gratings of the back and front reflectors is slightly different, to provide a Vernier tuning effect through varying the current supplied to these sections. The optical path length of the cavity can also be tuned with the phase section, for example by refractive index changes induced by varying the carrier density in this section. A more detailed description of the SG-DBR and other tunable multi-section diode lasers can be found in PCT patent publication number WO03/023916 entitled "Multi-section Diode Lasers".

Multi-section diode lasers are useful in wavelength division multiplexed (WDM) systems. Example applications are as transmitter sources, as wavelength converters in optical cross connects (OXCs) and for reference sources in heterodyne receivers. Typically, WDM systems have channel spacings conforming to the International Telecommunications Union (ITU) standard G692, which has a fixed point at 193.1 THz and inter-channel spacings at an integer multiple of 50 GHz or 100 GHz. An example dense WDM (DWDM) system could have a 50 GHz channel spacing and range from 191THz to 196THz (1525-1560 nm). The *raison d'etre* of multi-section diode lasers is their wavelength tunability. Each section of the laser diode is supplied with a drive current, and the lasing wavelength is a function of the set of drive currents, this function generally being quite complex. Setting the output wavelength of such a laser is thus usually performed by a sophisticated microprocessor controlled control system. As well as the fact that there is a complex relation between output wavelength and the set of drive currents, there is the additional factor that wavelength switching of the laser destroys its thermal equilibrium, which results in transient wavelength instabilities until thermal equilibrium is reached at the new set of drive currents. The time needed for temperature stabilisation can be quite long.

The transient thermal properties consist of two main effects. A first effect is that, directly after the laser is switched, the thermal gradient across the device to the heat sink upon which it is mounted will be different to that measured at steady state operating conditions for these currents, due to a different heating level generated in the laser as the currents are different. This steady state temperature gradient will reassert itself over a period measured in a timescale from a few hundred nanoseconds to tens of microseconds. Because the device is at a different temperature during this period some temperature tuning of the wavelength occurs. For a positive (negative) change in tuning current the change in temperature will be such that the device is initially colder (hotter) than at equilibrium for those currents and some time will pass before the extra current dissipates enough heat energy to change this. During that period the device will be colder (hotter) than expected so a blue (red) shift from the expected output wavelength will occur.

A second effect takes place over a much longer timescale. The laser is thermally connected to a heat sink of finite thermal mass which has a temperature controller maintaining its temperature. The temperature controller cannot react instantaneously to a change in temperature, which means that with an increase (decrease) in bias current, the heat sink will heat up (down). This in turn means that for a given temperature gradient the device will have a different temperature, because the temperature the gradient is referenced from will be different. This temperature change results in the temperature of the device overshooting and going higher (lower) than would be normal for those currents. This effect will persist until the temperature controller returns the heat sink to its normal temperature, which may take 1 - 1.5 seconds.

US2002/075918 and US2003/0147442 both describe an aging mechanism which takes the error in locking to a wavelength of a laser and adjusts the operating points to account for aging. Such mechanisms do not factor for the fast thermal effects in the laser, but rather adjust for slow changes in the device as it ages, so that the resultant error in any feedback control once the thermals have settled is small. These approaches therefore do not target minimising the wavelength error at the switch due to thermal effects, but rather minimise the wavelength error when the thermals have equalised.

US 2004/0120372 discloses a control circuit for a tunable laser what has a logic circuit configured to generate a plurality of digital control signals using a table of calibration parameters stored in that circuit. The logic circuit receives an input signal specifying an optical communication channel, retrieves the corresponding parameter values from the table of calibration parameters, and generates the digital control signals that are applied to the tunable laser. The table of calibration parameters may be periodically updated to correct for wavelength drifting due to laser aging.

To overcome the problems associated with transient (and non-transient) thermal effects, and also any other effects that cause the wavelength to deviate from the intended wavelength for a predetermined set of drive currents, a wavelength measuring system can be included which supplies measurements of the output wavelength to the control system. The laser drive current can then be adjusted in a feedback loop to provide locking of the output to the desired output wavelength. Feedback loops of this type can adjust and correct the wavelength error of the laser but typically require an amount of time to perform this compensation. This time to perform the compensation is problematic as the switching time of the laser is dependent on the magnitude of the wavelength error and the bandwidth of the feedback loop that can result in inefficient use of the laser.

There is therefore a need to provide a system and method that can reduce the initial wavelength error that will significantly reduce the switching time of the laser.

### Summary of the Invention

The object of the invention is fulfilled by a system and a method as defined in independent claims 1,10. Preferred embodiments are defined in the dependent claims.

The present invention, as set out in the appended claims, provides a laser system for switching from a current operating point to a new operating point of the laser, the laser operating at a particular wavelength and includes a source and destination, said system comprises:
means for enabling a feedback loop for adjusting settings of the laser based on a reference value, such as a wavelength locker;
means for transferring any adjustment caused to the settings of the laser by the feedback loop from the source to the destination channel; and means for utilising a compensation value based on the source and destination channels to adjust the destination channel settings.

The system switches and locks the output wavelength of a laser at ultra fast time scales (<50ns) and compensates for degradation in the laser, and thermal transients in the device during the switching to ensure that within a certain time the laser has switched its wavelength to another wavelength within a specific accuracy and is not dependent on the previous wavelength of the laser. This involves controlling the wavelength of a laser so that its output wavelength can be switching in an ultra-fast manner.

It will be appreciated that in the context of the present invention that the operating point is provided by the source channel and the new operating point is provided by the destination channel.

The present invention overcomes the thermal and optical properties of the laser that cause the output wavelength of the laser to drift from very short to very long time scales and includes a compensation factor for all thermal effects so that the switching time can be minimised.

Preferably, the feedback loop is a digital feedback loop or an analogue feedback loop.

Ideally, a wavelength reference is provided by means of a Fabry Perot etalon to provide a correction factor for the feedback loop.

Preferably, the settings of the laser effected by the feedback loop is the phase section of the laser.

Ideally there is provided means to adjust the destination settings based on a source channel of the laser.

In one embodiment the feedback loop correction comprises means to measure the amount of compensation provided by the feedback loop before the laser switch to provide a compensation factor for use in switching the laser to the new operating point. It will be appreciated that while locking the wavelength of the channel a correction value is obtained. This correction value may need to be adjusted so that the same correction factor can be applied to the new channel, and a compensation factor is used to convert this value and is an important aspect of implementing the invention. It will be appreciated that the laser system and others can be integrated with other functions such as optical amplifiers, optical modulators without limiting the scope of this invention.

Preferably, the compensation factor compensates for different bias conditions of the laser.

Ideally there is provided a lookup table stores a series of values for each channel of wavelength of the laser, said values comprising one or more of the following: bias settings, fine wavelength control setting, source compensation factor, destination compensation factor or channel conversion factor.

In a further embodiment a calculation is performed to determine a new operating point comprising:
means for obtaining the source compensation factor for the current channel and summing it with the destination compensation factor for a new channel;
means for multiplying the summed value by the channel compensation factor of the new channel and adding to the fine wavelength control setting of the new channel.

In a further embodiment there is provided a method of switching a laser system from a current operating point to a new operating point of the laser, the laser operating at a particular wavelength and includes a source and destination, said method comprising the steps of:
i) enabling a feedback loop for adjusting settings of the laser based on a reference value, such as a wavelength locker;
ii) transferring any adjustment caused to the settings of the laser by the feedback loop from the source to the destination channel; and
iii) utilising a compensation value based on the source and destination channels to adjust the destination channel settings.

There is also provided a computer program comprising program instructions for causing a computer program to carry out the above method which may be embodied on a record medium, carrier signal or read-only memory.

### Brief Description of the Drawings

The invention will be more clearly understood from the following description of an embodiment thereof, given by way of example only, with reference to the accompanying drawings, in which:-
Figure 1 illustrates a schematic of the implementation of a typical feedback loop for a multi-section laser;
Figure 2 illustrates a schematic of the implementation of the switching system and method according to the invention;
Figure 3 illustrates a representation of the lookup table defined in Figure 2;
Figure 4 illustrates a graphical representation of the calculation performed prior to a wavelength switch of the tunable laser; and
Figure 5 illustrates the effect of the invention on the wavelength error of the tunable laser.

### Detailed Description of the Drawings

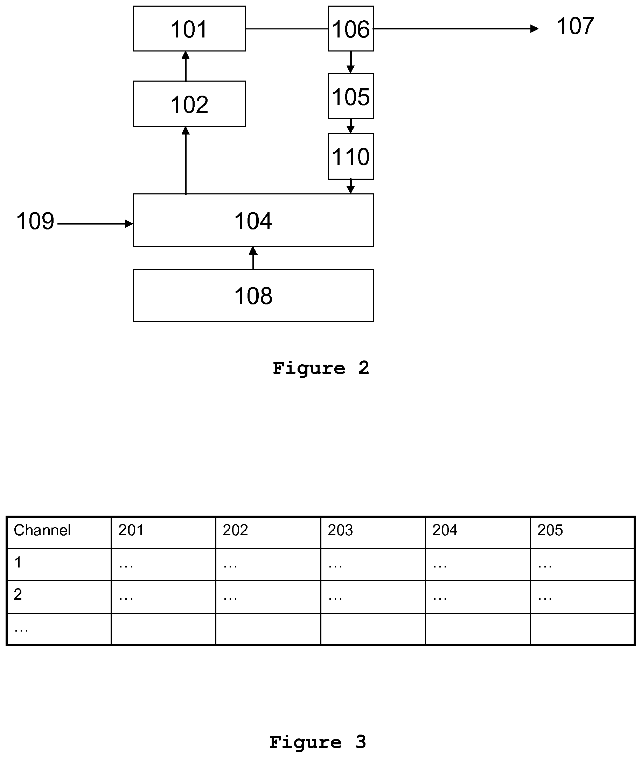

In accordance to this invention, an embodiment is shown in Figure 2 where a tunable laser (101) provides an optical output, which passes through a beam splitter (106) where some of the light emitted is directed to a wavelength reference (105) and the remaining light is directed to an output (107). The output from the wavelength reference (105) is passed to a photodiode and analogue to digital conversion (ADC) module (110). The digital output of the analogue to digital conversion is passed to a processor (104). In addition the processor has a lookup table (108) stored in memory which has the setup values for each wavelength desired of the tunable laser. These values can be set to the laser from the processor by sending them to the digital to analogue converters (102) and then through some conditioning electronics to the laser (101). A request to switch wavelength of the laser (101) can be provided to the processor (104) by means of an electrical interface (109).

In normal operation the processor adjusts control values of the laser so that the measured values from the wavelength reference reach a desired value, normally a specific wavelength of the laser. This is performed by measuring the voltage of the wavelength reference photodiode using an ADC (110), comparing it to a desired value and adjusting the set values of the laser via the DAC (102) to change the ADC value of the wavelength reference so that the value from this is closer to the desired value. This can be performed multiple times and is normally performed at a constant rate and in the form of a proportional, proportional and integral or proportional and integral and differential control (P,PI,PID respectively).

When a request is received by the processor (104) from the electrical interface (109) to switch the wavelength of the laser to a new operating point, or from one channel to a new channel, the processor firstly retrieves the required settings for the new channel from the lookup table (108).

The lookup table is provided in Figure 3 where a series of values are stored for each wavelength setting channel of the laser. These values are the bias settings of the tunable laser (201), the fine wavelength control setting of the laser (202), the source compensation factor (203), the destination compensation factor (204) and the channel conversion factor (205).

This lookup table can be generated from a calibration procedure to test various inputs to the laser and measure the output power and wavelength of the laser. From a sequence of these measurements a table can be generated where a set of inputs to the laser correspond to a specific output wavelength and power from the laser device.

In any switching of the laser a predetermined set of values are used to set the destination wavelength. For example, to adjust the wavelength may involve adjusting multiple inputs to the laser or other output characteristics jointly or separately from wavelength, such as optical output power from the laser.

There are three aspects of this invention, either alone or in any combination, that are used to achieve ultra-fast switching. The first is a means to lock the output wavelength of the laser using a feedback loop from a wavelength reference such as a fabry perot etalon and adjusting the inputs to the laser so that the wavelength adjusts to the desired wavelength. The second is to adjust the destination settings on the laser based on the source channel. The third is to measure the amount of compensation provided by the feedback loop just before the switch and convert this to a similar amount for the new wavelength and carry this compensation across the switch. The conversion compensates for different bias conditions of the laser from one operating point to the new operating point, for example taking into account the tuning efficiency of the laser as at one operating point a 2GHz error may result in a 5mA compensation but for another operating point the compensation required to generate a similar wavelength adjustment is 2mA.

The means for transferring any adjustment applied to the laser from a source to a destination channel is performed by determining the amount of adjustment applied, converting the adjustment applied to a corresponding adjustment at the destination and then adding the adjustment value to the destination channel. Determination of the adjustment value applied will take the difference between the unadjusted settings for the laser stored in the lookup table, and subtract them from the actual laser settings on the laser prior to switching the laser. Consideration should be taken of the source destination compensation which in normal cases should not be considered as part of the adjustment and should be removed from the actual laser settings before or added to the lookup table values before calculation of the laser adjustment.

The three components mentioned above allow ultra-fast switching such that the wavelength error at the time of switching is small and the feedback loop maintains this small error.

When the processor has retrieved the lookup table values for the new channel these are stored locally in registered titled new values. The previous lookup table values for the current channel are stored in local registered titled old values.

Initially a calculation is performed to determine the new settings for the tunable laser. This is determined by obtaining the source compensation factor for the current channel and summing it with the destination compensation factor for the new channel. This figure is then multiplied by the channel compensation factor of the new channel and added to the fine wavelength control setting of the new operating point or channel.

Then the current fine wavelength control setting is subtracted from the old fine wavelength control value to determine the difference between the old fine wavelength control setting and the current wavelength control setting. This is then divided by the compensation factor of the old channel and multiplied by the compensation factor of the new channel. The result is then added to the fine wavelength control value to be set to the laser. The processor is now prepared to switch to the new channel and performs the steps of:
A, turn off the feedback control loop
B, Set the new control values to the tunable laser
C, turn on the feedback control loop

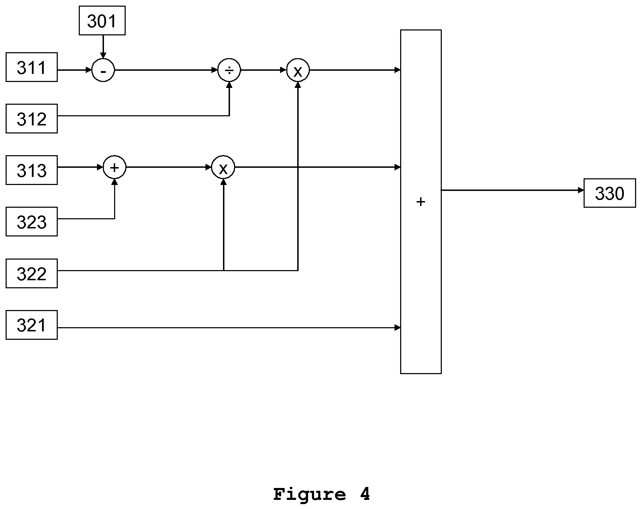

The above system is displayed schematically in Figure 4 where 301 is the current fine wavelength control setting, 311 is the old fine wavelength control setting, 312 is the old conversion factor, 313 is the old source compensation factor, 323 is the new destination compensation value, 322 is the new conversion factor and 321 is the new fine control wavelength value. The output (330) is used to set the fine wavelength control value of the laser and after the switch the old conversion factor (312) is updated with the new conversion factor (322), the old fine control wavelength value (311) is updated with the new fine control wavelength value (321), and the old source compensation value is updated with the new source compensation value.

The correct scaling of these parameters can ensure that the laser switches to the correct wavelength and the feedback loop ensures that the wavelength then remains at the correct wavelength.

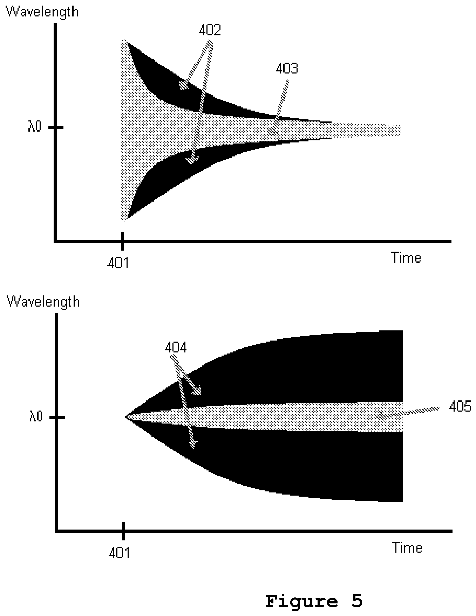

The effect of the invention on the wavelength error is shown in figure 5. The switching event is shown at 401 and the wavelength plots as a function of time from any other wavelength to the wavelength shown (lambda0) in the plot. The block region 402 is the possible wavelengths that can occur for each of the source channels without using any locking scheme. Using a feedback loop which compensates for wavelength error will reduce the errors to the grey region 403 but the initial error remains unchanged.

When the locking scheme of this invention is used the black region (404) shows the possible wavelengths of the laser depending on the previous operating point and when the wavelength feedback loop is employed the grey (405) region shows the possible wavelengths of the laser. As can be seen by reducing the initial wavelength spread the locking time of the laser can be greatly reduced

In another preferred embodiment of the invention an analogue feedback loop can be used instead of a digital feedback loop as described above. In this case an additional ADC is required to either measure the additional fine control voltage or current applied by the analogue feedback loop to replace the value calculated by the subtraction of the current fine control value (301) and old fine wavelength control value (311) in the previous embodiment.

In another embodiment the adjustment of the fine control wavelength value of the laser may be just settings to the phase section of the laser, or combinations of multiple sections of the laser according to some defined rules and or equations.

In another preferred embodiment of the invention the signs of each of the inputs to the summation prior to obtaining the fine wavelength control value to set to the laser can be altered dependent on the physical properties of the laser and feedback control used.

The words "comprises/comprising" and the words "having/including" when used herein with reference to the present invention are used to specify the presence of stated features, integers, steps or components but does not preclude the presence or addition of one or more other features, integers, steps, components or groups thereof.

It is appreciated that certain features of the invention, which are, for clarity, described in the context of separate embodiments, may also be provided in combination in a single embodiment. Conversely, various features of the invention which are, for brevity, described in the context of a single embodiment, may also be provided separately or in any suitable sub-combination. It will be further appreciated that the invention can be applied to any type of tunable laser system.

The embodiments in the invention described with reference to the drawings comprise a computer apparatus and/or processes performed in a computer apparatus. However, the invention also extends to computer programs, particularly computer programs stored on or in a carrier adapted to bring the invention into practice. The program may be in the form of source code, object code, or a code intermediate source and object code, such as in partially compiled form or in any other form suitable for use in the implementation of the method according to the invention. The carrier may comprise a storage medium such as ROM, e.g. CD ROM, or magnetic recording medium, e.g. a floppy disk or hard disk. The carrier may be an electrical or optical signal which may be transmitted via an electrical or an optical cable or by radio or other means.

## Claims

1. A laser system configured to switch from a current operating point to a new operating point of the laser, the laser operating at a particular wavelength and includes a source channel and destination channel, said system comprising:
a feedback loop enabled for adjusting settings of the laser (101) based on a reference value, such as a wavelength locker (105);
means adapted to transfer any adjustment caused to the settings of the laser (101) by the feedback loop from the source to the destination channel; and
means adapted to utilise a compensation value based on the source channel settings to adjust the destination channel settings, wherein the compensation value is determined as a difference between the unadjusted settings for the laser (101) stored in a lookup table and the actual laser settings just before switching to the destination channel, wherein the compensation value includes compensation for all thermal effects of the laser (101) so that the switching time is minimized, and wherein the feedback loop comprises means adapted to measure the amount of compensation provided by the feedback loop just before a laser switch to provide the compensation value for use in switching the laser (101) to the new operating point.

2. The laser system as claimed in claim 1 wherein the feedback loop is a digital feedback loop.

3. The laser system as claimed in claim 1 wherein the feedback loop is an analogue feedback loop.

4. The laser system as claimed in any preceding claim wherein a wavelength reference is provided by means of a Fabry Perot etalon.

5. The laser system as claimed in any preceding claim wherein the settings of the laser (101) effected are determined by a phase section of the laser.

6. The laser system as claimed in any preceding claim comprising means adapted to adjust the destination settings based on a source channel of the laser (101).

7. The laser system as claimed in claim 1 wherein the compensation value compensates for different bias conditions of the laser (101).

8. The laser system as claimed in any preceding claim wherein a lookup table (108) stores a series of values for each channel of wavelength of the laser (101), said values comprising one or more of the following: bias settings (201), fine wavelength control setting (202), source compensation factor (203), destination compensation factor (204) or channel conversion factor (205).

9. The laser system as claimed in claim 8 wherein a calculation is performed to determine the new operating point comprising:
means adapted to obtain the source compensation factor (203) from the current channel and summing it with the destination compensation factor (204) for a new channel;
means adapted to multiply the summed value by the channel compensation factor of the new channel and adding to the fine wavelength control setting of the new channel.

10. A method configured to switch a laser system from a current operating point to a new operating point of the laser, the laser operating at a particular wavelength and includes a source channel and destination channel, said method comprising the steps of:
enabling a feedback loop for adjusting settings of
the laser based on a reference value, such as a wavelength locker;
transferring any adjustment caused to the settings of the laser by the feedback loop from the source to the destination channel; and
utilising a compensation value based on the source channel settings to adjust the destination channel settings, wherein the compensation value is determined as a difference between the unadjusted settings for the laser stored in a lookup table and the actual laser settings just before switching to the destination channel, wherein the compensation value includes compensation for all thermal effects of the laser so that the switching time is minimized, and wherein the feedback loop measures the amount of compensation provided by the feedback loop just before a laser switch to provide the compensation value for use in switching the laser (101) to the new operating point.

11. A computer program comprising program instructions for causing a computer to perform the method of claim 10.

## Patentansprüche

1. Lasersystem, das dafür konfiguriert ist, von einem gegenwärtigen Betriebspunkt des Lasers auf einen neuen Betriebspunkt umzuschalten, wobei der Laser auf einer bestimmten Wellenlänge arbeitet und einen Ursprungskanal und einen Zielkanal beinhaltet, wobei das System Folgendes umfasst:
eine Rückkopplungsschleife, die für das Justieren von Einstellungen des Lasers (101) basierend auf einem Referenzwert freigegeben ist, wie beispielsweise einen Wellenlängen-Locker (105);
Mittel, die dafür eingerichtet sind, eine Justierung, die an den Einstellungen des Lasers (101) durch die Rückkopplungsschleife bewirkt wird, vom Ausgangs- zum Zielkanal zu übertragen; und
Mittel, die dafür eingerichtet sind, basierend auf den Ursprungskanal-Einstellungen einen Ausgleichswert zu verwenden, um die Zielkanaleinstellungen zu justieren, wobei der Ausgleichswert als eine Differenz zwischen den nicht justierten Einstellungen für den Laser (101), die in einer Nachschlagetabelle gespeichert sind, und den tatsächlichen Lasereinstellungen kurz vor dem Umschalten auf den Zielkanal bestimmt wird, wobei der Ausgleichswert einen Ausgleich für alle thermischen Effekte des Lasers (101) beinhaltet, so dass die Schaltzeit minimiert ist, und wobei die Rückkopplungsschleife Mittel umfasst, die dafür eingerichtet sind, den Umfang des Ausgleichs zu messen, der durch die Rückkopplungsschleife kurz vor dem Umschalten des Lasers bereitgestellt wird, um den Ausgleichswert zur Verwendung beim Umschalten des Lasers (101) auf den neuen Betriebspunkt bereitzustellen.

2. Lasersystem nach Anspruch 1, wobei die Rückkopplungsschleife eine digitale Rückkopplungsschleife ist.

3. Lasersystem nach Anspruch 1, wobei die Rückkopplungsschleife eine analoge Rückkopplungsschleife ist.

4. Lasersystem nach einem der vorhergehenden Ansprüche, wobei eine Wellenlängenreferenz mit Hilfe eines Fabry-Perot-Etalons bereitgestellt ist.

5. Lasersystem nach einem der vorhergehenden Ansprüche, wobei die bewirkten Einstellungen des Lasers (101) durch einen Phasenanschnitt des Lasers bestimmt sind.

6. Lasersystem nach einem der vorhergehenden Ansprüche, umfassend Mittel, die dafür eingerichtet sind, die Zieleinstellungen basierend auf einem Ursprungskanal des Lasers (101) zu justieren.

7. Lasersystem nach Anspruch 1, wobei der Ausgleichswert unterschiedliche Vorspannungsbedingungen des Lasers (101) ausgleicht.

8. Lasersystem nach einem der vorhergehenden Ansprüche, wobei eine Nachschlagetabelle (108) eine Reihe von Werten für jeden Wellenlängenkanal des Lasers (101) speichert, wobei die Werte eins oder mehrere des Folgenden umfassen: Vorspannungseinstellungen (201), Wellenlängen-Feinsteuerungseinstellung (202), Ausgangsausgleichsfaktor (203), Zielausgleichsfaktor (204) oder Kanalumwandlungsfaktor (205).

9. Lasersystem nach Anspruch 8, wobei eine Berechnung ausgeführt wird, um den neuen Betriebspunkt zu bestimmen, umfassend:
Mittel, die dafür eingerichtet sind, den Ausgangsausgleichsfaktor (203) aus dem gegenwärtigen Kanal zu erzielen und diesen für einen neuen Kanal zum Zielausgleichsfaktor (204) zu addieren;
Mittel, die dafür eingerichtet sind, den summierten Wert mit dem Kanalausgleichsfaktor des neuen Kanals zu multiplizieren und zur Wellenlängen-Feinsteuerungseinstellung des neuen Kanals zu addieren.

10. Verfahren, das dafür konfiguriert ist, ein Lasersystem von einem gegenwärtigen Betriebspunkt des Lasers auf einen neuen Betriebspunkt umzuschalten, wobei der Laser auf einer bestimmten Wellenlänge arbeitet und einen Ursprungskanal und einen Zielkanal beinhaltet, wobei das Verfahren folgende Schritte umfasst:
Freigeben einer Rückkopplungsschleife zum Justieren von Einstellungen des Lasers, basierend auf einem Referenzwert, wie beispielsweise eines Wellenlängen-Lockers,
Übertragen einer Justierung, die an den Einstellungen des Lasers durch die Rückkopplungsschleife bewirkt wird, vom Ursprungs- zum Zielkanal und
Verwenden eines Ausgleichswertes, basierend auf den Ursprungskanaleinstellungen, um die Zielkanaleinstellungen zu justieren, wobei der Ausgleichswert als eine Differenz zwischen den nicht justierten Einstellungen für den Laser, die in einer Nachschlagetabelle gespeichert sind, und den tatsächlichen Lasereinstellungen kurz vor dem Umschalten auf den Zielkanal bestimmt wird, wobei der Ausgleichswert einen Ausgleich für alle thermischen Effekte des Lasers beinhaltet, so dass die Schaltzeit minimiert wird, und wobei die Rückkopplungsschleife den Umfang des Ausgleichs misst, der durch die Rückkopplungsschleife kurz vor dem Umschalten des Lasers bereitgestellt wird, um den Ausgleichswert zur Verwendung beim Umschalten des Lasers (101) auf den neuen Betriebspunkt bereitzustellen.

11. Computerprogramm, umfassend Programmbefehle, die einen Computer veranlassen, das Verfahren von Anspruch 10 auszuführen.

## Revendications

1. Système laser configuré pour commuter d'un point de fonctionnement actuel à un nouveau point de fonctionnement du laser, le laser fonctionnant à une longueur d'onde particulière et comportant un canal source et un canal destination, ledit système comprenant :
une boucle de rétroaction validée pour ajuster les réglages du laser (101) d'après une valeur de référence, tel qu'un dispositif de verrouillage de longueur d'onde (105) ;
un moyen adapté pour transférer tout ajustement apporté aux réglages du laser (101) par la boucle de rétroaction du canal source au canal destination ; et
un moyen adapté pour utiliser une valeur de compensation d'après les réglages du canal source pour ajuster les réglages du canal destination, dans lequel la valeur de compensation est déterminée comme une différence entre les réglages non ajustés du laser (101) mémorisés dans une table de consultation et les réglages actuels du laser juste avant la commutation sur le canal destination, dans lequel la valeur de compensation comporte une compensation de tous les effets thermiques du laser (101) de telle sorte que le temps de commutation soit minimisé, et dans lequel la boucle de rétroaction comprend un moyen adapté pour mesurer la quantité de compensation apportée par la boucle de rétroaction juste avant une commutation du laser pour fournir la valeur de compensation à utiliser dans la commutation du laser (101) sur le nouveau point de fonctionnement.

2. Système laser selon la revendication 1 dans lequel la boucle de rétroaction est une boucle de rétroaction numérique.

3. Système laser selon la revendication 1 dans lequel la boucle de rétroaction est une boucle de rétroaction analogique.

4. Système laser selon l'une quelconque des revendications précédentes dans lequel une référence de longueur d'onde est fournie au moyen d'un étalon de Fabry Pérot.

5. Système laser selon l'une quelconque des revendications précédentes dans lequel les réglages du laser (101) effectués sont déterminés par une section de phase du laser.

6. Système laser selon l'une quelconque des revendications précédentes comprenant un moyen adapté pour ajuster les réglages de destination d'après un canal source du laser (101).

7. Système laser selon la revendication 1 dans lequel la valeur de compensation compense différentes conditions de polarisation du laser (101).

8. Système laser selon l'une quelconque des revendications précédentes dans lequel une table de consultation (108) mémorise une série de valeurs pour chaque canal de longueur d'onde du laser (101), lesdits valeurs comprenant une ou plusieurs des valeurs suivantes : réglages de polarisation (201), réglage de commande fine de longueur d'onde (202), facteur de compensation de source (203), facteur de compensation de destination (204) ou facteur de conversion de canal (205).

9. Système laser selon la revendication 8 dans lequel un calcul est effectué pour déterminer le nouveau point de fonctionnement comprenant :
un moyen adapté pour obtenir le facteur de compensation de source (203) à partir du canal actuel et l'ajouter au facteur de compensation de destination (204) pour un nouveau canal ;
un moyen adapté pour multiplier la valeur ajoutée par le facteur de compensation de canal du nouveau canal et l'ajouter au réglage de commande fine de longueur d'onde du nouveau canal.

10. Procédé configuré pour commuter un système laser d'un point de fonctionnement actuel à un nouveau point de fonctionnement du laser, le laser fonctionnant à une longueur d'onde particulière et comportant un canal source et un canal destination, ledit procédé comprenant les étapes consistant à :
valider une boucle de rétroaction pour ajuster les réglages du laser d'après une valeur de référence, tel qu'un dispositif de verrouillage de longueur d'onde ;
transférer tout ajustement apporté aux réglages du laser par la boucle de rétroaction du canal source au canal destination ; et
utiliser une valeur de compensation d'après les réglages du canal source pour ajuster les réglages du canal destination, dans lequel la valeur de compensation est déterminée comme une différence entre les réglages non ajustés du laser mémorisés dans une table de consultation et les réglages actuels du laser juste avant la commutation sur le canal destination, dans lequel la valeur de compensation comporte une compensation de tous les effets thermiques du laser de telle sorte que le temps de commutation soit minimisé, et dans lequel la boucle de rétroaction mesure la quantité de compensation apportée par la boucle de rétroaction juste avant une commutation du laser pour fournir la valeur de compensation à utiliser dans la commutation du laser (101) sur le nouveau point de fonctionnement.

11. Programme informatique comprenant des instructions de programme pour amener un ordinateur à exécuter le procédé selon la revendication 10.
